Europäisches Patentamt

European Patent Office

Office européen des brevets

(19)

(11) Veröffentlichungsnummer: **0 240 690 B1**

# (12) EUROPÄISCHE PATENTSCHRIFT

(45) Veröffentlichungstag der Patentschrift: **10.04.91**

(51) Int. Cl.⁵: **H01L 29/743**, H01L 29/52

(21) Anmeldenummer: **87102739.7**

(22) Anmeldetag: **26.02.87**

(54) Thyristor mit einstellbarem Basis-Emitter-Widerstand.

(30) Priorität: **05.03.86 DE 3607265**

(43) Veröffentlichungstag der Anmeldung:
**14.10.87 Patentblatt 87/42**

(45) Bekanntmachung des Hinweises auf die
Patenterteilung:
**10.04.91 Patentblatt 91/15**

(84) Benannte Vertragsstaaten:
**BE DE FR GB IT SE**

(56) Entgegenhaltungen:
**US-A- 4 063 278**
**US-A- 4 086 612**
**US-A- 4 210 924**
**US-A- 4 352 118**

(73) Patentinhaber: **Siemens Aktiengesellschaft**
**Wittelsbacherplatz 2**
**W-8000 München 2(DE)**

(72) Erfinder: **Voss, Peter, Dr.-Ing.**
**Rudliebstrasse 42**
**W-8000 München 81(DE)**

## Beschreibung

Die Erfindung bezieht sich auf einen Thyristor mit einem Halbleiterkörper mit den Merkmalen:

a) Die Emitterelektrode hat eine Aussparung,

b) der katodenseitige Basis-Emitter-pn-Übergang tritt innerhalb der Aussparung an die katodenseitige Oberfläche des Halbleiterkörpers,

c) auf den innerhalb der Aussparung an die Oberfläche tretenden Teil der Basiszone sitzt eine Gateelektrode,

d) zwischen der Emitterelektrode und der Gateelektrode liegt ein in den Halbleiterkörper integrierter ohmscher Widerstand, der durch lokale Überbrückung des pn-Übergangs durch die Gateelektrode oder die Emitterelektrode gebildet ist.

Thyristoren dieser Art sind beispielsweise im US-Patent 4,086,612 beschrieben worden. Der genannte integrierte Widerstand hat den Zweck, die du/dt-Festigkeit des Thyristors zu verbessern. Er kann durch einen Vorsprung des Basis-Emitter-pn-Übergangs gebildet werden, der unter die Gateelektrode oder unter die Emitterelektrode reicht.

Solche wie auch andere Thyristoren ein- und desselben Typs benötigen im allgemeinen zum Zünden aufgrund unvermeidlicher Fertigungstoleranzen unterschiedlich hohe Zündströme. Diese Zündströme dürfen einen bestimmten Streubereich nicht überschreiten.

Der Erfindung liegt die Aufgabe zugrunde, einen Thyristor der eingangs erwähnten Art so weiterzubilden, daß der erwähnte integrierte Widerstand leicht zu justieren ist, so daß der Zündstrom nach Fertigstellung des Thyristors auf einen Wert innerhalb des Streubereichs eingestellt werden kann.

Diese Aufgabe wird dadurch gelöst, daß die Emitterelektrode einen als Vorsprung ausgebildeten Metallsteg aufweist, und daß der Metallsteg den pn-Übergang lokal überbrückt.

Damit wird ein einstellbarer Nebenschluß zum Strompfad Gateelektrode-pn-Übergang-Emitterzone geschaffen, durch den abhängig von seiner Größe ein mehr oder weniger großer Teil des Zündstroms unter Umgehung des pn-Übergangs direkt zur Emitterelektrode fließen kann.

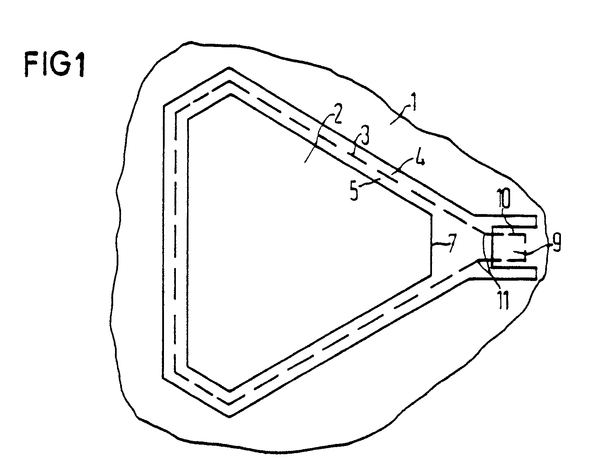

Die Erfindung wird anhand einiger Ausführungsbeispiele in Verbindung mit den Figuren 1 bis 3 näher erläutert. Sie zeigen die Aufsicht auf drei verschiedene Ausführungsbeispiele eines Thyristors gemäß der Erfindung. Dabei sind gleiche oder funktionsgleiche Teile mit den gleichen Bezugsziffern versehen.

In FIG 1 ist die Emitterelektrode eines Thyristors mit 1 bezeichnet. Sie weist eine Aussparung auf, innerhalb der zwischen der Emitterzone 4 und der Basiszone 5 liegende pn-Übergang 3 an die Oberfläche des Halbleiterkörpers tritt. Die Basiszone 5 ist mit einer Gateelektrode 2 kontaktiert. Die Basiszone 5 hat einen in die Emitterzone 4 ragenden Finger 9. Die Emitterelektrode 1 hat ihrerseits einen als Vorsprung ausgebildeten Metallsteg 10. Dieser Metallsteg 10 kontaktiert den Finger 9. Der Basis-Emitter Widerstand wird durch Abstand des Metallsteges 10 von der Kante 7 der Gateelektrode 2 eingestellt. Der Widerstand ist dann durch einen Teil der Basiszone 5 gebildet.

Die Emitterelektrode 2, der pn-Übergang 3 und die Aussparung der Emitterelektrode 1 sind polygonförmig ausgebildet. Der pn-Übergang hat beim Übergang in den Finger 9 Ecken 11 mit einem Winkel 180°, bezogen auf die Emitterzone. An diesen Ecken könnte für den Fall eine Zündung einsetzen, wenn der Metallsteg 10 diese Ecken nicht bedeckt. Daher muß der Abstand zwischen den Ecken 11 und der Gateelektrode 2 auf jeden Fall größer sein als der Abstand zwischen der Gateelektrode und dem pn-Übergang im übrigen Bereich des Thyristors.

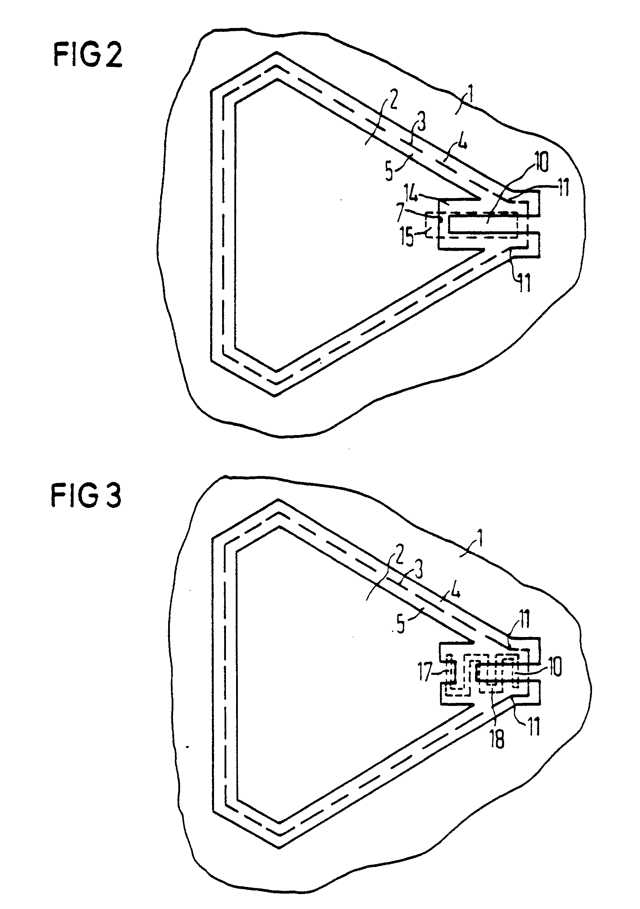

Im Ausführungsbeispiel nach Fig. 2 ist in die Basiszone 5 eine Zone 15 vom entgegengesetzten Leitungstyp eingebettet. Diese Zone wird einerseits von dem Metallsteg 10 der Emitterelektrode 1 kontaktiert und reicht andererseits in eine Aussparung 14 der Gateelektrode hinein bis unter die Gateelektrode 2. Der Widerstand wird durch ein Teil der Zone 15 gebildet. Seine Größe wird im wesentlichen durch den Abstand zwischen Metallsteg 10 und der geraden Kante 7 der Gateelektrode bestimmt. Für den Abstand der Ecken 11 des pn-Übergangs 3 von der Gateelektrode gilt das gleiche, was in Verbindung mit Fig. 2 erläutert wurde. Die Zone kann z. B. eine Länge von 2 mm, eine Breite von 100 μm und einen Widerstand von 0,5 $\Omega/\square$ haben.

In Fig. 3 ist eine Abwandlung des Ausführungsbeispiels nach Fig. 2 dargestellt. Die in die Basiszone eingebettete Zone entgegengesetzten Leitungstyps ist hier mäanderförmig ausgebildet und mit 18 bezeichnet. Zur gateelektrodenseitigen Kontaktierung der Zone 18 hat die Gateelektrode eine Zunge 17. Der Basis-Emitter-Widerstand kann hier durch die Länge des Stegs 10 und/oder der Zunge 17 stufenweise dadurch eingestellt werden, daß jeweils ein anderer Quersteg der Zone 18 kontaktiert wird.

Solange die Verbindung zwischen 17 und 18 nicht aufgetrennt werden muß, kann die Zone 18 auch mit dem Emitter 4 verbunden sein. Würde die Verbindung zwischen 17 und 18 jedoch getrennt, so wäre dann damit zu rechnen, daß sich an den der Gateelektrode gegenüberliegenden Ecken von 18 bevorzugte Zündpunkte ausbilden.

Die Ausführungsbeispiele bezogen sich auf polygonale Konfigurationen. Es ist aber auch möglich, die Gateelektrode 2, den pn-Übergang 3 und die Aussparung der Emitterelektrode 1 im wesentlichen kreisrund auszuführen. Der einstellbare Widerstand wird dann entsprechend durch eine Ausnehmung, Metallstege oder Finger gebildet.

Bei im wesentlichen kreisrunden Anordnungen besteht allerdings die Gefahr, daß bei völliger Unterbrechung des Nebenschlusses für den Zündstrom ein Stromlinienverlauf entsteht, der zu bevorzugten Stellen für die Zündung führt.

Die Ausführungsbeispiele beziehen sich auf einen einzigen Basis-Emitternebenschluß. Es ist jedoch auch möglich, mehrere vorzugsweise symmetrisch angeordnete Widerstände vorzusehen.

## Ansprüche

1. Thyristor mit einem Halbleiterkörper mit den Merkmalen:

   a) Die Emitterelektrode (1) hat eine Aussparung,

   b) der katodenseitige Basis-Emitter-pn-Übergang (3) tritt innerhalb der Aussparung an die katodenseitige Oberfläche des Halbleiterkörpers,

   c) auf den innerhalb der Aussparung an die Oberfläche tretenden Teil der Basiszone sitzt eine Gateelektrode (2),

   d) zwischen der Emitterelektrode (1) und der Gateelektrode (2) liegt ein in den Halbleiterkörper integrierter ohmscher Widerstand, der durch lokale Überbrückung des pn-Übergangs (3) durch die Gateelektrode oder die Emitterelektrode gebildet ist,

   **dadurch gekennzeichnet,** daß die Emitterelektrode (1) einen als Vorsprung ausgebildeten Metallsteg (10) aufweist und daß der Metallsteg den pn-Übergang lokal überbrückt.

2. Thyristor nach Anspruch 1,
   **dadurch gekennzeichnet,** daß die Basiszone (5) einen in die Emitterzone (1) ragenden Finger (9) aufweist und daß der Finger durch den Metallsteg (10) kontaktiertist.

3. Thyristor nach Anspruch 2,
   **dadurch gekennzeichnet,** daß die Gateelektrode (2) am Umfang eine Aussparung (14) hat, in die der Metallsteg (10) hineinragt.

4. Thyristor nach Anspruch 1,
   **dadurch gekennzeichnet,** daß in die Basiszone eine streifenförmige Zone (15) entgegengesetzten Leitungstyps eingebettet ist, daß der Metallsteg (10) den pn-Übergang (3) lokal überbrückt und die streifenförmige Zone kontaktiert, daß die Gateelektrode (2) die streifenförmige Zone kontaktiert und daß der ohmsche Widerstand durch die streifenförmige Zone (15) gebildet ist.

5. Thyristor nach Anspruch 4,
   **dadurch gekennzeichnet,** daß die Gateelektrode eine Aussparung (14) hat, in die die streifenförmige Zone hineinragt und bis unter die Gateelektrode reicht.

6. Thyristor nach Anspruch 4,
   **dadurch gekennzeichnet,** daß die streifenförmige Zone (18) mäanderförmig ausgebildet ist.

## Claims

1. Thyristor having a semiconductor body with the following characteristics:

   a) the emitter electrode (1) has a recess,

   b) the base-emitter p-n junction (3) on the cathode side emerges inside the recess at the surface of the semiconductor body on the cathode side,

   c) a gate electrode (2) is seated on the part of the base zone emerging at the surface inside the recess,

   d) an ohmic resistor which is integrated in the semi-conductor body and which is formed by local bridging of the p-n junction (3) by the gate electrode or the emitter electrode is situated between the emitter electrode (1) and the gate electrode (2), characterised in that the emitter electrode (1) has a metal bridge (10) formed as a projection and in that the metal bridge locally bridges the p-n junction.

2. Thyristor according to Claim 1, characterised in that the base zone (5) has a finger (9) projecting into the emitter zone (1) and in that the finger is contacted by the metal bridge (10).

3. Thyristor according to Claim 2, characterised in that the gate electrode (2) has at the periphery a recess (14) into which the metal bridge (10) projects.

4. Thyristor according to Claim 1, characterised in that a strip-like zone (15) of opposite conduction type is embedded in the base zone, in that the metal bridge (10) locally bridges the p-n junction (3) and contacts the strip-like zone, in that the gate electrode (2) contacts the strip-like zone, and in that the ohmic resistor is formed by the strip-like zone (15).

5. Thyristor according to Claim 4, characterised in that the gate electrode has a recess (14) into which the strip-like zone projects and extends to a point underneath the gate electrode.

6. Thyristor according to Claim 4, characterised in that the strip-like zone (18) is of meandering construction.

## Revendications

1. Thyristor comportant un corps semiconducteur, présentant les caractéristiques suivantes:
   a) l'électrode d'émetteur (1) possède un évidement,
   b) la jonction pn base-émetteur (3), située du côté de la cathode, pénètre dans l'évidement, au niveau de la surface du corps semiconducteur tournée vers la cathode,
   c) une électrode de grille (2) est disposée sur la partie de la zone de base, située sur la surface à l'intérieur de l'évidement,
   d) entre l'électrode d'émetteur (1) et l'électrode de grille (2) est disposée une résistance ohmique, intégrée dans le corps semiconducteur et formée par shuntage local de la jonction pn (3) par l'électrode de grille ou l'électrode d'émetteur,
   caractérisé par le fait que l'électrode d'émetteur (1) possède une barrette métallique (10) réalisée en forme d'élément saillant et que la barrette métallique shunte localement la jonction pn.

2. Thyristor suivant la revendication 1, caractérisé par le fait que la zone de base (5) possède un doigt (9) pénétrant dans la zone d'émetteur (1) et que la barrette métallique (10) est en contact avec le doigt.

3. Thyristor suivant la revendication 2, caractérisé par le fait que l'électrode de grille (2) possède, sur son pourtour, un évidement (14), dans lequel pénètre la barrette métallique (10).

4. Thyristor suivant la revendication 1, caractérisé par le fait que dans la zone de base est insérée une zone en forme de bande (15) possédant un type de conductivité opposé, que la barrette métallique (10) shunte localement la jonction pn (3) et est en contact avec la zone en forme de bande, que l'électrode de grille (2) est en contact avec la zone en forme de bande et que la résistance ohmique est formée par la zone en forme de bande (15).

5. Thyristor suivant la revendication 4, caractérisé par le fait que l'électrode de grille possède un évidement (14), dans lequel pénètre la zone en forme de bande, qui s'étend jusqu 'au-dessous de l'électrode de grille.

6. Thyristor suivant la revendication 4, caractérisé par le fait que la zone en forme de bande (18) est réalisée avec une forme sinueuse.

**FIG1**

FIG 2

FIG 3